# EUROPEAN PATENT APPLICATION

(11) **EP 1 953 740 A2**
(43) Date of publication of application: **06.08.2008**
(21) Application number: 07122015.6
(22) Date of filing: 30.11.2007
(51) Int. Cl.: G11B 5/39

(54) **Tunnel magnetoresistence effect film and magnetic device**

(30) Priority: 31.01.2007 JP 2007022160
(71) Applicant: Fujitsu Ltd., Kawasaki-shi, Kanagawa 211-8588 (JP); TOHOKU UNIVERSITY, Sendai, Miyagi 980-8577 (JP)
(72) Inventor: Takahashi, Migaku, Sendai-shi Kanagawa 980-8577 (JP); Tsunoda, Masakiyo, Sendai-shi Miyagi 980-8577 (JP); Komagaki, Kojiro c/o Fujitsu Limited, Kawasaki-shi Kanagawa 211-8588 (JP)
(74) Representative: Fenlon, Christine Lesley

(57) **Abstract**

The tunnel magnetoresistance effect film is a highly practical tunnel magnetoresistance effect film having a characteristic of serviceable negative MR ratio, which can be used at room temperature. The tunnel magnetoresistance effect film comprises: a tunnel barrier layer (13); and magnetic layers sandwiching the tunnel barrier layer (13). One of the magnetic layers is composed of FeN (12).

## Description

### BACKGROUND OF THE INVENTION

The present invention relates to a tunnel magnetoresistance effect film and a magnetic device using the tunnel magnetoresistance effect film.

A magnetic head of a magnetic disk apparatus comprises: a write-head, which writes data on a recording medium; and a read-head, which reads written data from the recording medium. The read-head has a magnetoresistance effect element, whose resistance value is varied on the basis of magnetization signals recorded on the recording medium. The magnetoresistance effect element (read-element) includes a magnetoresistance effect film, in which magnetic layers and nonmagnetic layers are laminated. A TMR (Tunnel MagnetoResistance) element has a film structure of "a magnetic layer/a tunnel barrier layer/a magnetic layer". Namely, it is characterized in that the tunnel barrier layer is sandwiched between the magnetic layers. In the TMR element, a sense current passes perpendicular to the surface of the magnetoresistance effect film so as to detect variation of a resistance value.

A resistance value of a magnetoresistance effect film, in which the magnetization directions of the magnetic layers sandwiching the tunnel barrier layer are parallel, is different from that of a magnetoresistance effect film, in which the magnetization directions of the magnetic layers sandwiching the tunnel barrier layer are antiparallel. MR ratio is defined by increasing rate of the resistance value of the parallel case (P) and that of the antiparallel case (AP). Namely, MR ratio = (R_{AP} - R_{P})/ R_{P} × 100.

In case of the conventional TMR type magnetoresistance effect film, the resistance value of the antiparallel case, in which the magnetization directions of the magnetic layers sandwiching the tunnel barrier layer are antiparallel, is greater than that of the parallel case, in which the magnetization directions of the magnetic layers sandwiching the tunnel barrier layer are parallel. Namely, the magnetoresistance effect film has a characteristic of positive MR ratio.

On the other hand, materials having negative MR ratio (inverse MR) have been reported (see Phys. Rev. Lett. 82(1999)4288; Phys. Rev. Lett. 82(1999)616; and Phys. Rev. Lett. 90(2003)186602). In each of such materials, the resistance value of the parallel case, in which the magnetization directions of the magnetic layers sandwiching the tunnel barrier layer are parallel, is greater than that of the antiparallel case, in which the magnetization directions of the magnetic layers sandwiching the tunnel barrier layer are antiparallel. MR ratios of the magnetoresistance effect films having characteristics of negative MR ratio are smaller than those of the magnetoresistance effect films having characteristics of positive MR ratio, but their characteristics will be applied to new magnetic devices. Note that, the document Phys. Rev. Lett. 82(1999)4288 discloses a magnetoresistance effect film having a characteristic of negative MR ratio, whose film structure is Co/SrTiO/LaSrMnO; the document Phys. Rev. Lett. 82(1999)616 discloses a magnetoresistance effect film having a characteristic of negative MR ratio, whose film structure is NiFe/TaAIO/NiFe; and the document Phys. Rev. Lett. 90(2003)186602 discloses a magnetoresistance effect film having a characteristic of negative MR ratio, whose film structure is Ni/NiO/Co.

As described above, some magnetoresistance effect films having characteristics of negative MR ratio have been reported. However, in case of the magnetoresistance effect film whose film structure is Co/SrTiO/LaSrMnO, the MR ratio is great, e.g., -50%, but the magnetic layer of LaSrMnO is an oxide layer and service temperature is very low, e.g., 5K. Further, in case of the magnetoresistance effect film whose film structure is NiFe/TaAIO/NiFe, the materials used in the conventional magnetoresistance effect film can be used, but the MR ratio is small, e.g., -4%. In case of the magnetoresistance effect film whose film structure is Ni/NiO/Co, the materials used in the conventional magnetoresistance effect film can be used, but an element size is very small, e.g., 60 nm or less, and service temperature is very low, e.g., 4.2K.

Since MR ratios of the conventional magnetoresistance effect films having characteristics of negative MR ratio are small, they cannot be used for magnetic heads instead of the conventional films having great MR ratios. Further, service temperature is very low, so they cannot be applied to utility devices.

### SUMMARY OF THE INVENTION

It is desirable to provide a highly practical tunnel magnetoresistance effect film having a characteristic of serviceable negative MR ratio, which can be used at room temperature, and a magnetic device using the tunnel magnetoresistance effect film.

A tunnel mangetoresistance effect film embodying a first aspect of the present invention comprises: a tunnel barrier layer; and magnetic layers sandwiching the tunnel barrier layer, and one of the magnetic layers is a FeN layer.

In a tunnel magnetoresistance effect film embodying the first aspect of the present invention, the other magnetic layer may be a pinned magnetic layer whose magnetization direction is fixed. With this structure, the magnetization direction of the one magnetic layer is varied when an external magnetic field works thereto, so that the external magnetic field can be detected as variation of a resistance value of the tunnel magnetoresistance effect film.

In a tunnel magnetoresistance effect film embodying the first aspect of the present invention, the pinned magnetic layer may be constituted by a first pinned magnetic layer and a second pinned magnetic layer, which are coupled by an antiferromagnetic coupling layer. Further, an antiferromagnetic layer may be adjacently formed to the pinned magnetic layer, and the antiferromagnetic layer may switch-connect the pinned magnetic layer so as to fix magnetization of the pinned magnetic layer. With these structures, the magnetization direction of the magnetic layer can be stably maintained.

A magnetic device embodying a second aspect of the present invention comprises a tunnel magnetoresistance effect film, the tunnel magnetoresistance effect film comprising: a tunnel barrier layer; and magnetic layers sandwiching the tunnel barrier layer, one of the magnetic layers being a FeN layer. A magnetic device embodying a second aspect of the present invention can be applied to, for example, a magnetic head, in which the tunnel magnetoresistance effect film is used as a magnetoresistance effect film of a read-element of a read-head, and a magnetic memory.

A magnetic device embodying a third aspect of the present invention comprises: a first tunnel magnetoresistance effect film section including a pinned magnetic layer, a tunnel barrier layer and a magnetic layer having a characteristic of positive MR ratio; and a second tunnel magnetoresistance effect film section including a pinned magnetic layer, a tunnel barrier layer and a magnetic layer having a characteristic of negative MR ratio, wherein the magnetic layer of the second tunnel magnetoresistance effect film section, which has the characteristic of negative MR ratio, is a FeN layer.

In a magnetic device embodying the third aspect of the present invention, each of the pinned magnetic layers may be constituted by a first pinned magnetic layer and a second pinned magnetic layer. Further, an antiferromagnetic layer may be adjacently formed to each of the pinned magnetic layers, and the antiferromagnetic layer may be switch-connect each of the pinned magnetic layers, so as to fix magnetization of the pinned magnetic layers.

In a magnetic device embodying the third aspect of the present invention, a common pinned magnetic layer may act as the pinned magnetic layers of the first tunnel magnetoresistance effect film section and the second tunnel magnetoresistance effect film section, and the tunnel barrier layer and the magnetic layer of the first tunnel magnetoresistance effect film section and those of the second tunnel magnetoresistance effect film section may be separately formed on the common pinned magnetic layer. With this structure, the magnetic device can be used as, for example, a memory element.

Further, in a magnetic device embodying the third aspect of the present invention, the first tunnel magnetoresistance effect film section and the second tunnel magnetoresistance effect film section may be serially connected between an earth and a source, the pinned magnetic layers may be connected to a gate, and inversion of an input signal, which is caused by an external magnetic field, may be detected as an inverted output signal of the gate. With this structure, the magnetic device can be used as a logical circuit for an inverter.

A tunnel magnetoresistance effect film embodying the present invention has a great negative MR ratio, e.g., -30%, at the room temperature, so it can be applied to utility products, e.g., magnetic memory, with exploiting a characteristic of the negative MR ratio. Further, a magnetic device embodying the present invention can be used at room temperature and easily treated, so practical magnetic devices can be produced.

### BRIEF DESCRIPTION OF THE DRAWINGS

Embodiments of the present invention will now be described by way of examples and with reference to the accompanying drawings, in which:
Fig. 1A is an explanation view of a read-element using a tunnel magnetoresistance effect film embodying the present invention;
Fig. 1B is an explanation view of a previously-proposed read-element;
Fig. 2A is a graph showing negative MR ratio of a tunnel magnetoresistance effect film embodying the present invention;
Fig. 2B is a graph showing positive MR ratio of the previously-proposed tunnel magnetoresistance effect film;
Fig. 3 is an explanation view of a magnetic device using a tunnel magnetoresistance effect film having negative MR ratio;
Fig. 4 is a logical circuit of the magnetic device shown in Fig. 3; and
Fig. 5 is an explanation view explaining action of the magnetic device shown in Fig. 3.

### DETAILED DESCRIPTION OF THE EMBODIMENTS

Preferred embodiments of the present invention will now be described in detail with reference to the accompanying drawings.

### (Structure of Tunnel Magnetoresistance Effect Film)

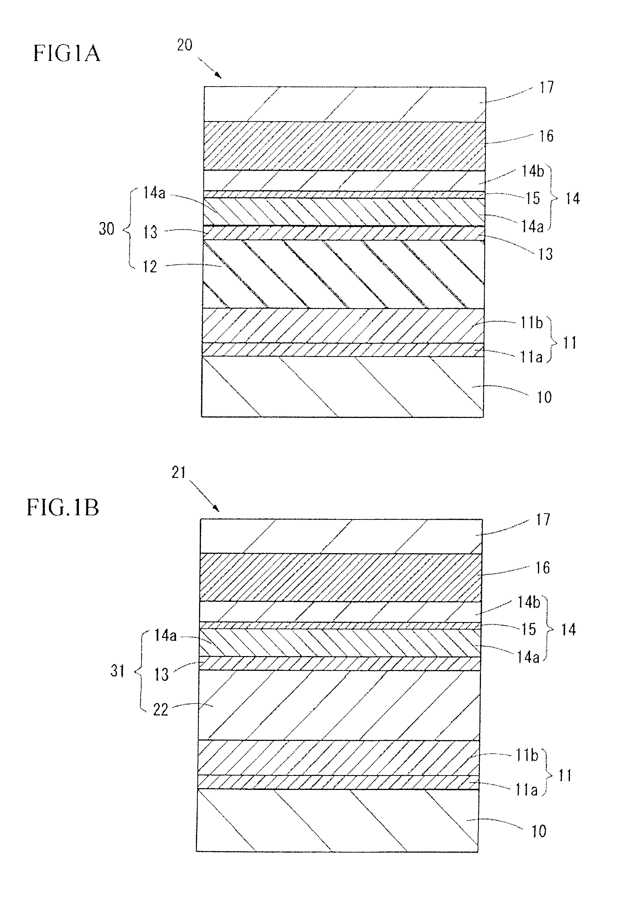

Figs. 1A and 1B show structures of read-elements of magnetic heads, each of which has a tunnel magnetoresistance effect film. Fig. 1A shows a read-element 20 having the tunnel magnetoresistance effect film of the present invention; Fig. 1B is an explanation view of a previously-proposed read-element 21 having a previously-proposed tunnel magnetoresistance effect film.

In the read-element 21 shown in Fig. 1A, a base layer 11 constituted by a first base layer 11a and a second base layer 11b, a FeN (nitriding iron) layer 12 which is a magnetic layer, a tunnel barrier layer 13 which is an insulating layer, a pinned magnetic layer 14, an antiferromagnetic layer 16 and a cap layer 17 are formed on a substrate 10, which is composed of AITiC, in that order. Note that, the pinned magnetic layer 14 is constituted by a first magnetic layer 14a, an antiferromagnetic coupling layer 15 and a second magnetic layer 14b.

In the read-element 20, the tunnel magnetoresistance effect film 30 of the present invention is constituted by the FeN layer 12, the tunnel barrier layer 13 and the first magnetic layer 14a. The tunnel barrier layer 13 is sandwiched between the FeN layer 12 and the first magnetic layer 14a. The FeN layer 12 is a free layer, whose magnetization direction can be varied by an external magnetic field, and the first magnetic layer 14a acts as a pinned layer, whose magnetization direction is previously fixed.

The antiferromagnetic layer 16, which is laminated on the pinned magnetic layer 14, is switch-connected to the second magnetic layer 14b so as to fix the magnetization direction of the second magnetic layer 14b. Since the first magnetic layer 14a and the second magnetic layer 14b are antiferromagnetically coupled, the magnetization direction of the first magnetic layer 14a can be stably fixed.

Various film structures can be employed for the read-element 20, and various materials can be used for the layers. An example of the film structure shown in Fig. 1A will be explained.

The first base layer 11 a is composed of MgO whose thickness is 2 nm; the second base layer 11b is composed of Fe whose thickness is 5 nm; the FeN layer 12 is composed of Fe₄N whose thickness is 5 nm; the tunnel barrier layer 13 is composed of MgO whose thickness is 2 nm; the first magnetic layer 14a is composed of CoFeB whose thickness is 4 nm; the antiferromagnetic layer 15 is composed of Ru whose thickness is 0.85 nm; the second magnetic layer 14b is composed of Fe whose thickness is 3 nm; the antiferromagnetic layer 16 is composed of Mnlr whose thickness is 7.5 nm; and the cap layer 17 is composed of Ta whose thickness is 5 nm.

The previously-proposed read-element 21 shown in Fig. 1B has the previously-proposed TMR type magnetoresistance effect film. In comparison with the read-element 20 shown in Fig. 1A, the unique point of the read-element 21 is a magnetic layer 22, which is formed under a tunnel barrier layer 13, only. The magnetic layer 22 acts as a free layer of the read-element 21, and it is composed of a soft magnetic material, e.g., NiFe.

In the read-element 21 shown in Fig. 1B, the tunnel magnetoresistance effect film 31 is constituted by the magnetic layer 22, the tunnel barrier layer 13 and a first magnetic layer 14a. The film structure and materials of the read-element 21, other than the magnetic layer 22, are the same as those of the read-element 20 shown in Fig. 1A.

The read-element 21 shown in Fig. 1B, which has the TMR type magnetoresistance effect film, is a previously-proposed example. On the other hand, in the read-element 20 shown in Fig. 1A, the FeN layer 21 is used instead of the magnetic layer 22 of the previously-proposed TMR type magnetoresistance effect film.

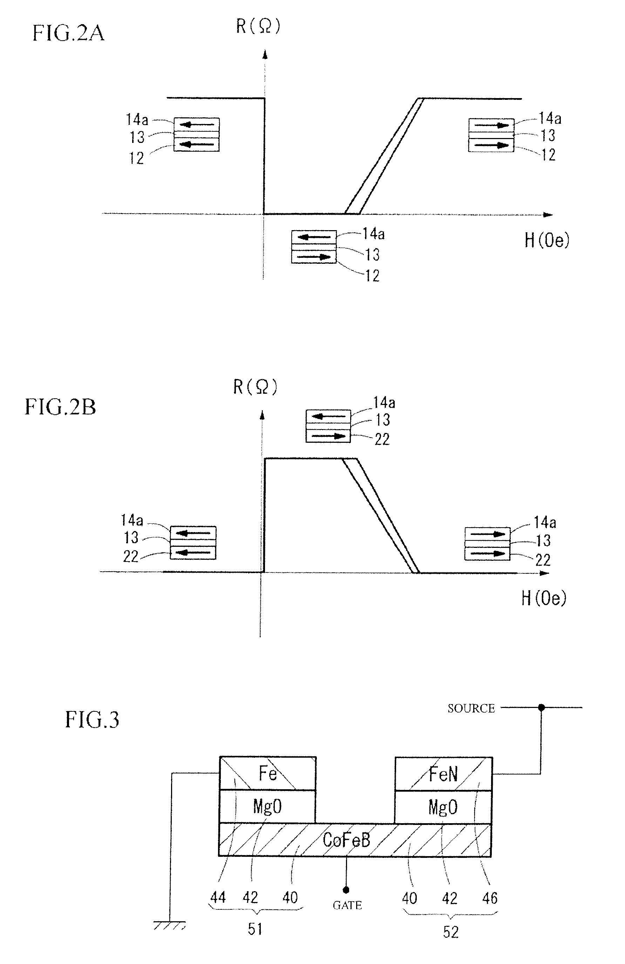

Fig. 2A is a graph showing MR ratio of a tunnel magnetoresistance effect film 30 embodying the present invention; Fig. 2B is a graph showing MR ratio of the previously-proposed tunnel magnetoresistance effect film 31.

As shown in Fig. 2B, in the previously-proposed tunnel magnetoresistance effect film 31, the resistance value of an antiparallel case, in which the magnetization directions of the magnetic layer 22 and the first magnetic layer 14a are antiparallel, is greater than that of a parallel case, in which the magnetization directions of the magnetic layers 22 and 14a are parallel. Namely, the magnetoresistance effect film has a characteristic of positive MR ratio.

On the other hand, as shown in Fig. 2A, in the tunnel magnetoresistance effect film 30 embodying the present invention, the resistance value of the antiparallel case, in which the magnetization directions of the FeN layer 12 and the first magnetic layer 14a are antiparallel, is smaller than that of the parallel case, in which the magnetization directions of the magnetic layers 12 and 14a are parallel. Namely, the magnetoresistance effect film has a characteristic of negative MR ratio. According to an experiment, the above described tunnel magnetoresistance effect film, whose structure is Fe₄N (5 nm)/MgO (2 nm)/CoFeB (4 nm), had MR ratio of -30 % at the room temperature.

Since the high negative MR ratio, e.g., -30 %, can be gained at the room temperature, the tunnel magnetoresistance effect film of the present invention can be used for a read-head of a magnetic head. Generally, characteristics of a magnetic head can be made stable by increasing an absolute value of MR ratio. Therefore, in case of using the tunnel magnetoresistance effect film having the characteristic of negative MR ratio for a read-element of a magnetic head, the magnetoresistance effect film having greater MR ratio is required.

### (Magnetic Device)

A random access memory, in which the tunnel magnetoresistance effect films having the characteristic of negative MR ratio are used, will be explained as an example of a magnetic device embodying the present invention.

In Fig. 3, the random access memory is constituted by: tunnel magnetoresistance effect films having the characteristic of positive MR ratio, in each of which a film structure is Fe (a magnetic layer)/MgO (a tunnel barrier layer)/CoFeB (a magnetic layer); and tunnel magnetoresistance effect films having the characteristic of negative MR ratio, in each of which a film structure is FeN (a magnetic layer)/MgO (a tunnel barrier layer)/CoFeB (a magnetic layer).

In the magnetic device shown in Fig. 3, the Fe layer 44 and the FeN layer 46 are formed on the common pinned magnetic layer 40, which is composed of CoFeB and acts as a common magnetic layer, with the tunnel barrier layers 42 respectively. The Fe layer 44 and the FeN layer 46 are slightly separated. The pinned magnetic layer 40 composed of CoFeB is a ferromagnetic layer, whose magnetization direction is not varied by an external magnetic field, and the magnetization direction is previously fixed in a magnetizing process. On the other hand, magnetization directions of the Fe layer 44 and the FeN layer 46 are varied by an external magnetic field.

To fix the magnetization direction of the pinned magnetic layer 40, the pinned magnetic layer 40 may be formed by laminating a plurality of pinned magnetic layers with antiferromagnetic coupling layers. Further, a plurality of antiferromagnetic layers may be laminated so as to fix the magnetization direction of the pinned magnetic layer by switch-connecting function.

The tunnel barrier layers 42 are sandwiched between the pinned magnetic layer 40, the Fe layer 44 and the FeN layer 46. A section 51, in which the Fe layer 44 is formed, is a first tunnel magnetoresistance effect film section, which is constituted by the pinned magnetic layer 40, the tunnel barrier layer 42 and the Fe layer 44; a section 52, in which the FeN layer 46 is formed, is a second tunnel magnetoresistance effect film section, which is constituted by the pinned magnetic layer 40, the tunnel barrier layer 42 and the FeN layer 46.

The second tunnel magnetoresistance effect film section 52 having the FeN layer 46 has the characteristic of negative MR ratio; the first tunnel magnetoresistance effect film section 51 having the Fe layer 44 has the characteristic of positive MR ratio.

In Fig. 3, no substrate is shown, but the pinned magnetic layer 40, the tunnel barrier layers 42, the Fe layer 44 and the FeN layer 46 are formed on the substrate by sputtering. Thicknesses and planar patterns of the pinned magnetic layer 40, the tunnel barrier layers 42, the Fe layer 44 and the FeN layer 46 may be optionally formed by a conventional film forming process.

The Fe layer 44 is connected to an earth (ground); the FeN layer 46 is connected to a source electrode; and the pinned magnetic layer 40 is connected to a gate electrode.

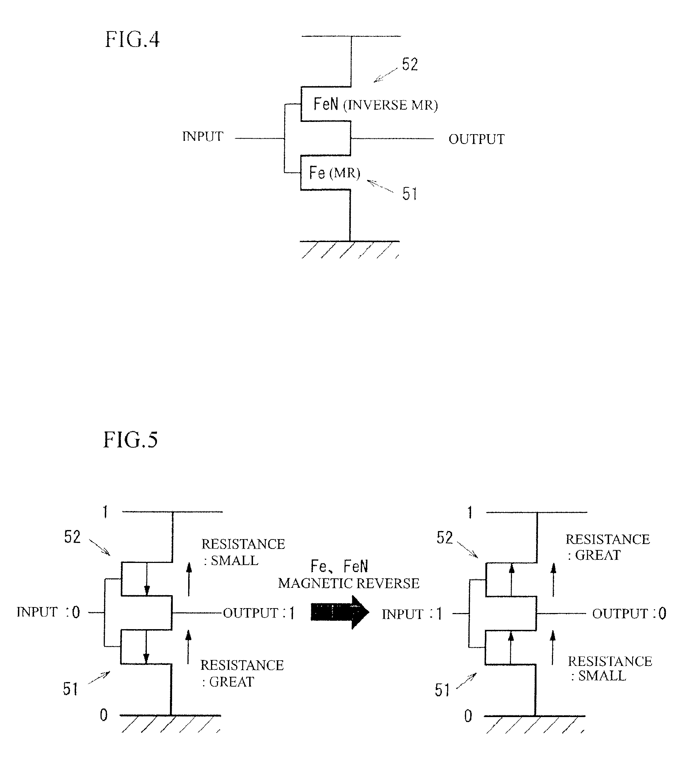

Fig. 4 is a logical circuit of the magnetic device shown in Fig. 3. The first tunnel magnetoresistance effect film section 51 and the second tunnel magnetoresistance effect film section 52 are serially connected between the earth and the source electrode. A signal is outputted from the pinned magnetic layer 40.

An input signal acts as an external magnetic field working to the magnetic device. Namely, when the external magnetic field works to the Fe layer 44 and the FeN layer 46 of the magnetic device so as to reverse the magnetization directions, resistance values of the first tunnel magnetoresistance effect film section 51 and the second tunnel magnetoresistance effect film section 52 are varied, so that an output signal of the gate is varied. The external magnetic field for reversing the magnetization directions of the Fe layer 44 and the FeN layer 46 of the magnetic device can be applied by, for example, providing a cable near the magnetic device and switching a direction of a current passing through the cable.

The first tunnel magnetoresistance effect film section 51 has the characteristic of positive MR ratio, and the second tunnel magnetoresistance effect film section 52 has the characteristic of negative MR ratio. Therefore, resistance value relation between the parallel case and the antiparallel case of the first tunnel magnetoresistance effect film section 51 is opposite to that of the second tunnel magnetoresistance effect film section 52. By employing this function, the logical circuit shown in Fig. 4 can be used as an inverter circuit.

Fig. 5 shows the action of the above described magnetic device. When a signal inputted to the magnetic device is 0, i.e., the external magnetic field is applied so as to make the magnetization directions of the Fe layer 44 and the FeN layer 46 of the magnetic device opposite to that of the pinned magnetic layer 40, the magnetization directions of the pinned magnetic layer 40 and the Fe layer 40 are made antiparallel in the first tunnel magnetoresistance effect film section 51, so that the resistance value is increased; the magnetization directions of the pinned magnetic layer 40 and the FeN layer 46 are made antiparallel in the second tunnel magnetoresistance effect film section 52, so that the resistance value is reduced. Therefore, the gate-output is 1 (voltage: High).

On the other hand, when the signal inputted to the magnetic device is 1, i.e., the external magnetic field is applied so as to make the magnetization directions of the Fe layer 44 and the FeN layer 46 of the magnetic device parallel to that of the pinned magnetic layer 40, the resistance value is reduced in the first tunnel magnetoresistance effect film section 51; the resistance value is increased in the second tunnel magnetoresistance effect film section 52, so that the resistance value is reduced. Therefore, the gate-output is 0 (voltage: Low).

As described above, the above described inverter action, in which the gate outputs the signal 1 or 0 when the signal 0 or 1 is inputted, is performed. By applying the external magnetic field to the magnetic device, the inverter action is performed. If no external magnetic field works to the magnetic device, the magnetic device maintains the former state. Namely, the magnetic device can be used as a random access memory.

In case of using the magnetic device as the random access memory, magnetizing directions are merely held or maintained, so the great MR ratio is not required. Therefore, a tunnel magnetoresistance effect film embodying the present invention can be suitably used in the above magnetic device. Especially, a tunnel magnetoresistance effect film embodying the present invention has the great MR ratio, e.g., -30%, and can be used at room temperature. Therefore, a tunnel magnetoresistance effect film embodying the present invention can be widely applied to various magnetic devices including magnetic heads.

The invention may be embodied in other specific forms without departing from the spirit of essential characteristics thereof. The present embodiments are therefore to be considered in all respects as illustrative and not restrictive, the scope of the invention being indicated by the appended claims rather than by the foregoing description and all changes which come within the meaning and range of equivalency of the claims are therefore intended to be embraced therein.

## Claims

1. A tunnel magnetoresistance effect film,
comprising:
a tunnel barrier layer (13); and
magnetic layers sandwiching said tunnel barrier layer (13),
wherein one of said magnetic layers is a FeN layer (12).

2. The tunnel magnetoresistance effect film according to claim 1,
wherein the other magnetic layer is a pinned magnetic layer (14) whose magnetization direction is fixed.

3. The tunnel magnetoresistance effect film according to claim 2,
wherein the pinned magnetic layer (14) is constituted by a first pinned magnetic layer (14a) and a second pinned magnetic layer (14b), which are coupled by an antiferromagnetic coupling layer (15).

4. The tunnel magnetoresistance effect film according to claim 2 or 3,
wherein an antiferromagnetic layer (16) is adjacently formed to the pinned magnetic layer (14), and
the antiferromagnetic layer (16) switch-connects the pinned magnetic layer (14) so as to fix magnetization of the pinned magnetic layer (14).

5. A magnetic device,
comprising:
a tunnel magnetoresistance effect film,
wherein said tunnel magnetoresistance effect film comprises: a tunnel barrier layer (13); and magnetic layers sandwiching said tunnel barrier layer (13), and
one of said magnetic layers is a FeN layer (12).

6. A magnetic device,
comprising:
a first tunnel magnetoresistance effect film section (51) including a pinned magnetic layer (40), a tunnel barrier layer (42) and a magnetic layer (44) having a characteristic of positive MR ratio; and
a second tunnel magnetoresistance effect film section (52) including a pinned magnetic layer (40), a tunnel barrier layer (42) and a magnetic layer (40) having a characteristic of negative MR ratio,
wherein the magnetic layer (46) of said second tunnel magnetoresistance effect film section (52), which has the characteristic of negative MR ratio, is a FeN layer.

7. The magnetic device according to claim 6,
wherein each of the pinned magnetic layer (40) is constituted by a first pinned magnetic layer (14a) and a second pinned magnetic layer (14b), which are coupled by an antiferromagnetic coupling layer (15)

8. The magnetic device according to claim 6 or 7,
wherein an antiferromagnetic layer (16) is adjacently formed to each of the pinned magnetic layers (14a, 14b), and
the antiferromagnetic layer (16) switch-connects each of the pinned magnetic layers (14a, 14b) so as to fix magnetization of the pinned magnetic layers.

9. The magnetic device according to claim 6, 7 or 8,
wherein a common pinned magnetic layer (40) acts as the pinned magnetic layers of said first tunnel magnetoresistance effect film section (51) and said second tunnel magnetoresistance effect film section (52), and
the tunnel barrier layer (42) and the magnetic layer of said first tunnel magnetoresistance effect film section (51) and those of said second tunnel magnetoresistance effect film section (52) are separately formed on the common pinned magnetic layer (40).

10. The magnetic device according to claim 9,
wherein said first tunnel magnetoresistance effect film section (51) and said second tunnel magnetoresistance effect film section (52) are serially connected between an earth and a source,
the pinned magnetic layer (40) is connected to a gate, and
inversion of an input signal, which is caused by an external magnetic field, is detected as an inverted output signal of the gate.
